# EUROPEAN PATENT APPLICATION

(11) **EP 4 657 520 A2**
(43) Date of publication of application: **03.12.2025**
(21) Application number: 25157524.7
(22) Date of filing: 12.02.2025
(51) Int. Cl.: H01L 23/373

(54) **CONTROLLING BOND LINE THICKNESS (BLT) FOR METAL**

(30) Priority: 13.02.2024 US 202463552988 P
(71) Applicant: Laird Technologies, Inc., Chesterfield, MO 63017 (US)
(72) Inventor: HODUL, John N., Chesterfield, Missouri, 63017 (US); WEMP, Claire K., Chesterfield, Missouri, 63017 (US); STRADER, Jason L., Chesterfield, Missouri, 63017 (US)
(74) Representative: Greif, Thomas

(57) **Abstract**

Disclosed are exemplary methods for controlling or manipulating bond line thickness for metal amalgams including filler particles (e.g., metal amalgam thermal interface materials (TIMs), etc.) through shearing, sonication, and/or vibration of the metal amalgam under pressure to achieve lower bond line thicknesses. In an exemplary method, a metal amalgam including filler particles may be used as a thermal interface material between a heat source and another component of an electronic device, whereby the metal amalgam has a bond line thickness of less than 100 micrometers.

## Description

### FIELD

The present disclosure generally relates to controlling bond line thickness (BLT) for metal amalgams including filler particles (*e.g.*, metal amalgam including metal filler particles usable as a thermal interface material (TIM), *etc*.)*.*

### BACKGROUND

This section provides background information related to the present disclosure which is not necessarily prior art.

Electrical components, such as semiconductors, integrated circuit packages, transistors, *etc.,* typically have pre-designed temperatures at which the electrical components optimally operate. Ideally, the pre-designed temperatures approximate the temperature of the surrounding air. But the operation of electrical components generates heat. If the heat is not removed, the electrical components may then operate at temperatures significantly higher than their normal or desirable operating temperature. Such excessive temperatures may adversely affect the operating characteristics of the electrical components and the operation of the associated electronic device.

To avoid or at least reduce the adverse operating characteristics from the heat generation, the heat should be removed, for example, by conducting the heat from the operating electrical component to a heat sink. The heat sink may then be cooled by conventional convection and/or radiation techniques. During conduction, the heat may pass from the operating electrical component to the heat sink either by direct surface contact between the electrical component and heat sink and/or by contact of the electrical component and heat sink surfaces through an intermediate medium or thermal interface material. The thermal interface material may be used to fill the gap between thermal transfer surfaces, in order to increase thermal transfer efficiency as compared to having the gap filled with air, which is a relatively poor thermal conductor.

### DRAWINGS

The drawings described herein are for illustrative purposes only of selected embodiments and not all possible implementations, and are not intended to limit the scope of the present disclosure.

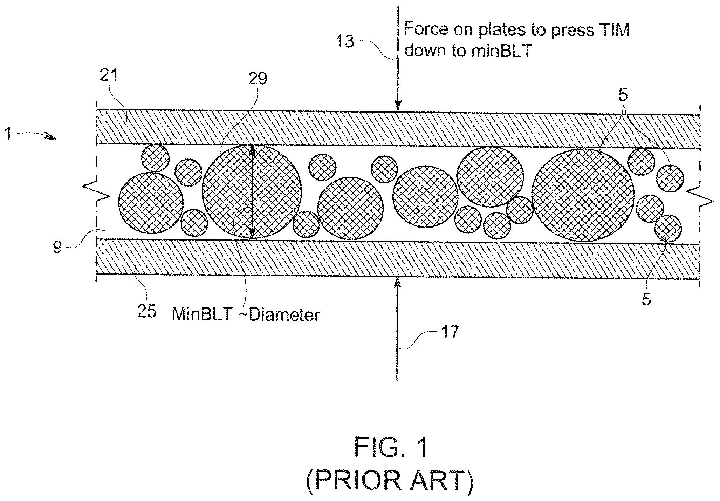

FIG. 1 illustrates a conventional polymer thermal interface material (TIM) 1 including differently sized filler particles 5 mixed into a polymer matrix 9. Forces 13 and 17 are applied on plates 21 and 25 to press the polymer TIM down to a minimum bond line thickness (minBLT). As shown in FIG. 1, the largest particle size 29 typically dictates the minimum bond line thickness for the conventional polymer TIM.

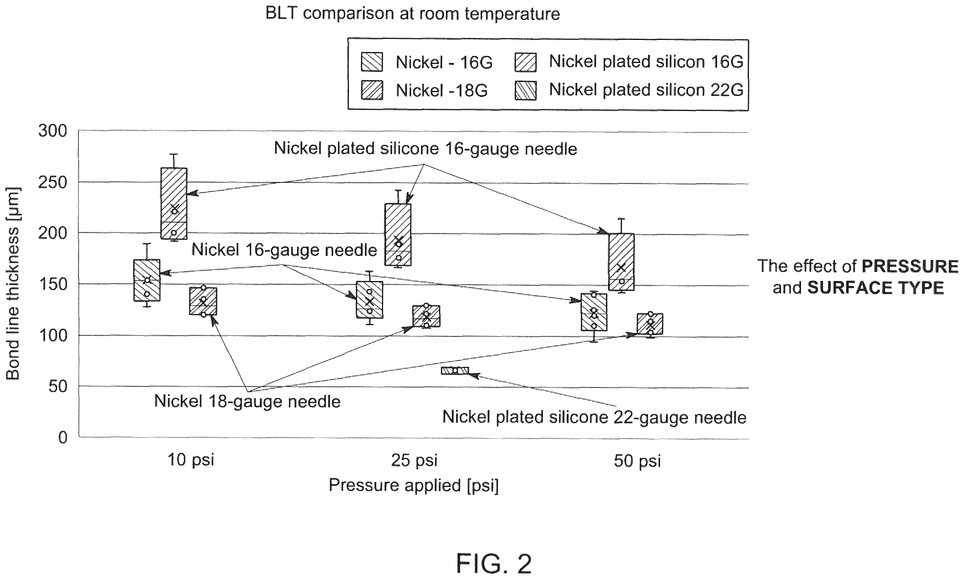

FIG. 2 graphically illustrates bond line thickness (BLT) data in micrometers (µm), which data was obtained at room temperature for a metal amalgam filled or loaded with (*e.g.,* about 1 weight percent (wt%) to about 10 wt%, *etc.*) of nickel and copper between different substrates/surfaces that contact the filled metal amalgam during the application of pressure. For this exemplary testing, pressure was applied to the filled metal amalgam with bare silicon on one side and either machined nickel or nickel plated silicon on the other side. Pressures are specified in pounds per square (psi), and different gauge needles (16G, 18G, or 22G) are represented as different colors. Generally, FIG. 2 shows the effect of pressure alone and surface type on the bond line thickness of a metal amalgam. As recognized herein, there are diminishing returns as pressure alone is increased such that minimum bond line thickness (BLT) is not achieved even with very high pressures that might otherwise damage electronic components. Instead, minimum bond line thickness is achievable via shearing while under pressure as disclosed herein.

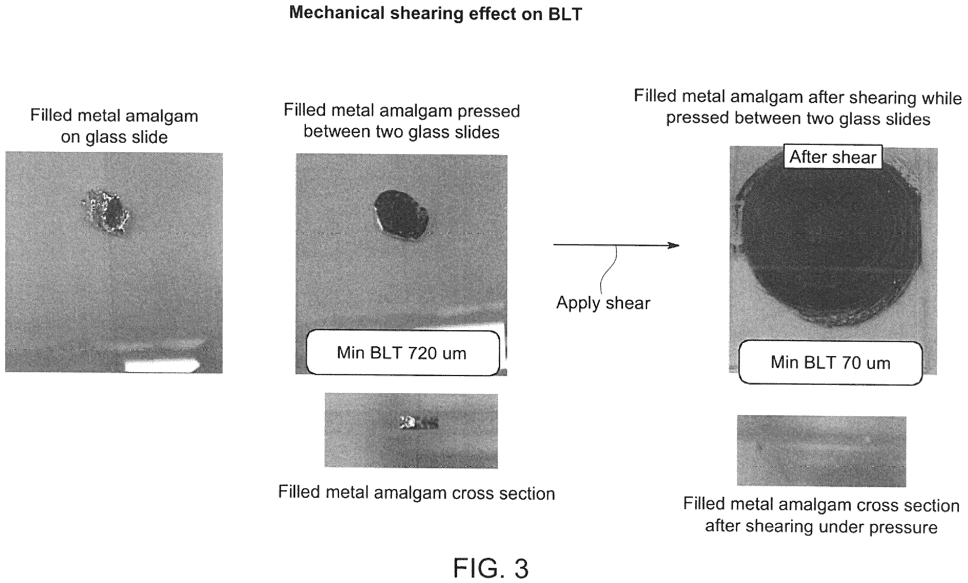

FIG. 3 includes color photographs generally showing the mechanical shearing effect on bond line thickness of a metal amalgam filled or loaded with (*e.g*., about 1 wt% to about 10 wt%, *etc*.) of nickel and copper.

Corresponding reference numerals may indicate corresponding (though not necessarily identical) features throughout the several views of the drawings.

### DETAILED DESCRIPTION

Example embodiments will now be described more fully with reference to the accompanying drawings.

As recognized herein, conventional pure liquid metal thermal interface materials (TIMs) require a gasket or spacer to hold a bond line that is greater than zero. This is because conventional liquid metals do not contain any fillers and do not possess any bond line thickness (BLT) control. Accordingly, unfilled liquid metal TIMs have no ability to hold a bond line thickness. For conventional polymer-based TIM materials, the minimum bond line thickness is related to the pressure applied. And as shown in FIG. 1, the largest particle size 29 typically dictates the minimum bond line thickness for the conventional polymer TIM.

After recognizing the above, exemplary embodiments were developed and/or are disclosed herein in which a metal amalgam including filler particles (*e.g*., gallium-indium-tin liquid metal alloy including nickel particles and copper particles, *etc.*) undergoes shearing, sonification, and/or vibration while under pressure.

When a metal amalgam is pressed without a shearing, sonification, and/or vibration process, the resulting bond line thickness can be equal to or greater than 10 times the original filler particle size. Through application of a shearing force, sonification, and/or vibration while under pressure, the bond line thickness of the metal amalgam is able to be reduced to thereby achieve a true minimum bond line thickness of the metal amalgam. This may be unique to metal amalgams in which the filler particles (*e.g*., metal filler particles, *etc..*) do not allow for the lowest minimum bond line thickness without the shearing, sonification, and/or vibration under pressure. Advantageously, exemplary embodiments disclosed herein provide or allow for a filled metal amalgam system to achieve reduced or minimum bond line thicknesses under 100 micrometers (*e.g.,* about 10 micrometers, *etc.*)*.* And with the reduced bond line thickness of the metal amalgam, thermal resistance can thus be reduced while still maintaining the rheological advantages of a filled liquid metal system versus a non-filled liquid metal system.

As further recognized herein, larger bond line thicknesses can be controlled through the filler particle loading whereby higher filler particle loadings result in thicker bond line thicknesses of the metal amalgam. Bond lines thickness can be manipulated through shearing, vibration, and/or sonication while under pressure to achieve lower bond line thickness.

Bond line thickness is capable of being manipulated and decreased with shearing, vibration, and/or sonication while under pressure. Bond line thickness will be different depending on substrate with data showing that the smoother the substrate, the higher the bond line thickness.

The technique used to apply (*e.g*., dispense, *etc.*) the metal amalgam and resulting bond line thickness is controllable based on total filler particle loading. For example, metal amalgams with lower filler particle loadings may be dispensable onto a surface (*e.g*., a heat source or other component of an electronic device, *etc.*) while metal amalgams with higher filler particle loadings may need to be applied via other methods.

By way of example, a metal amalgam may comprise gallium-indium-tin liquid metal alloy (or other liquid metal, low melting alloy, *etc.*) including about 1 percent to about 10 percent of nickel and copper particles (*e.g*., about 4 volume percent (vol%) of nickel particles and copper particles, *etc.*)*.* The filler particle loading may be sufficiently low to enable the metal amalgam to be dispensable. In this example, the metal amalgam may be dispensed on a heat source or another component of an electronic device. After the metal amalgam is dispensed, a heat sink or another heat dissipation component may be applied to (*e.g.,* on top of, *etc.*) the metal amalgam such that a shearing force and pressure are applied to the metal amalgam that reduces or minimizes the bond line thickness of the metal amalgam between the heat source or another component of the electronic device and the heat sink or another heat dissipation component. The metal amalgam may establish a thermal path through which a heat is flowable from the heat source during operation of the electronic device whereby temperature of the heat source is reduced.

It has also been recognized herein that when applying a filled metallic TIM material (*e.g*., gallium-indium-tin liquid metal alloy including nickel particles and copper particles with about a 1:1 to 5:1 ratio of nickel to copper, other metal amalgam, *etc.*) on a test head as a droplet, the achieved bond line thickness may vary depending on the following factors: applied pressure, droplet size, speed of closure (of test heads), substrate surface in contact with material, mechanical twisting/application technique, sonication, or vibration of the substrate surface, and filler particle loading. As generally shown in FIG. 2, the applied pressure and substrate surface in contact with the metal amalgam are factors that may be used in a method of controlling bond line thickness.

Disclosed are exemplary methods for controlling or manipulating bond line thickness for metal amalgams including filler particles (*e.g*., metal amalgam including metal filler particles usable as a thermal interface material (TIM), *etc.)* through shearing, sonication, and/or vibration of the metal amalgam under pressure to achieve lower bond line thicknesses. In an exemplary method of controlling bond line thickness (BLT) of a metal amalgam including filler particles (*e.g*., metal filler particles, *etc..*), the method comprises shearing, sonication, and/or vibration of the metal amalgam while pressing the metal amalgam down to a reduced bond line thickness. In an exemplary method of forming a thermal joint with a metal amalgam including filler particles (*e.g*., metal filler particles, *etc..*), the method comprises shearing, sonication, and/or vibration of the metal amalgam under pressure down to achieve a reduced bond line thickness of the metal amalgam. In an exemplary method, a metal amalgam including filler particles (*e.g*., metal filler particles, *etc..*), may be used as a thermal interface material between a heat source and another component of an electronic device, whereby the metal amalgam has a bond line thickness of less than 100 micrometers. Also disclosed are methods of optimizing bond line thicknesses through optimal patterning/application method and pattern height which dictates the achievable bond line thickness.

In exemplary embodiments, the method includes shearing, sonication, and/or vibration of the metal amalgam while simultaneously pressing the metal amalgam to reduce the bond line thickness of the metal amalgam. For example, the method may include shearing, sonication, and/or vibration of the metal amalgam while pressing the metal amalgam down to a minimum bond line thickness (*e.g*., less than 100 micrometers, about 70 micrometers, about 10 micrometers, *etc.*)*.* The method may include shearing, sonication, and/or vibration of the metal amalgam while pressing the metal amalgam down to a minimum bond line thickness of greater than 10 times an original metal particle filler size in the metal amalgam. The method may include compressing the metal amalgam between upper and lower plates or substrates.

In exemplary embodiments, the method includes dispensing or applying the metal amalgam on a heat source or another component of an electronic device before shearing, sonication, and/or vibration of the metal amalgam under pressure.

In exemplary embodiments, the method includes dispensing or applying the metal amalgam on a heat source or another component of an electronic device. The method also includes applying a heat sink or another heat dissipation component to the metal amalgam such that a shearing force and pressure are applied to the metal amalgam that reduces or minimizes the bond line thickness of the metal amalgam between the heat source or another component of the electronic device and the heat sink or another heat dissipation component.

In exemplary embodiments, the metal amalgam comprises a liquid metal filled with metal filler particles. And the method includes dispensing or applying the liquid metal filled with metal filler particles on a surface before shearing, sonication, and/or vibration of the metal amalgam under pressure.

In exemplary embodiments, the metal amalgam comprises a liquid metal filled with metal filler particles. And the method includes dispensing or applying the liquid metal filled with metal filler particles on a heat source or another component of an electronic device. The method also includes applying a heat sink or another heat dissipation component to the liquid metal filled with metal filler particles such that a shearing force and pressure are applied to the liquid metal filled with metal filler particles that reduces or minimizes the bond line thickness of the liquid metal filled with metal filler particles between the heat source or another component of the electronic device and the heat sink or another heat dissipation component.

In exemplary embodiments, the metal amalgam comprises a liquid metal filled with metal filler particles. And the method includes shearing, sonication, and/or vibration of the liquid metal filled with metal filler particles under pressure such that after the shearing, sonication, and/or vibration of the liquid metal filled with metal filler particles under pressure, the liquid metal filled with metal filler particles is controllable and able to hold a bond line thicker than a largest particle size of the metal filler particles.

In exemplary embodiments, the method includes controlling bond line thickness of the metal amalgam through the filler particle loading of the metal amalgam whereby higher filler particle loadings result in thicker bond line thicknesses of the metal amalgam.

In exemplary embodiments, the method includes controlling bond line thickness of the metal amalgam through the selection of substrate(s)/surface(s) that contact the metal amalgam during the method whereby smoother substrate(s)/surface(s) result in thicker bond line thicknesses of the metal amalgam.

In exemplary embodiments, the method enables filled metal amalgam systems to achieve bond line thicknesses under 100 micrometers, thereby reducing thermal resistance while maintaining rheological advantages of a filled metal amalgam system versus a non-filled liquid metal system.

In exemplary embodiments, the metal amalgam consists of only metal(s).

In exemplary embodiments, the metal amalgam comprises gallium, indium, tin, nickel, and copper.

In exemplary embodiments, the metal amalgam comprises nickel particles and copper particles such that the metal amalgam includes a ratio of the nickel to the copper within a range from about 1:1 to about 5:1 by weight percent (wt%) and/or by volume percent (vol%). For example, the metal amalgam may comprise nickel particles and copper particles such that the metal amalgam includes about a 2:1 ratio of nickel to copper by weight percent (wt%) and/or by volume percent (vol%).

In exemplary embodiments, the metal amalgam comprises nickel particles and copper particles such that the metal amalgam is loaded with about 1 percent to about 10 percent of nickel and copper. For example, the metal amalgam may comprise about 5 volume percent (vol%) of nickel particles and about 2.5 volume percent (%vol) of copper particles such that the metal amalgam is loaded with about 7.5 volume percent (vol%) of the nickel particles and the copper particles. Or the metal amalgam may comprise nickel particles and copper particles such that the metal amalgam is loaded with about 4 volume percent (vol%) of the nickel particles and the copper particles.

In exemplary embodiments, the metal amalgam comprises a maximum loading of no more than about 10 weight percent of the filler particles. For example, the metal amalgam comprises nickel particles and copper particles such that the metal amalgam includes a maximum loading of no more than about 10 weight percent of the copper particles and the nickel particles.

In exemplary embodiments, the method includes using the metal amalgam having the reduced bond line thickness to form a thermal joint between a heat source of an electronic device and another component of the electronic device.

In exemplary embodiments, the reduced bond line thickness of the metal amalgam forming the thermal joint allows for a reduced overall electronic device thickness and reduced thermal resistance across the thermal joint thereby resulting in a lower temperature for the heat source during operation of the electronic device.

Also disclosed are exemplary embodiments of thermal interface materials (TIMs) for establishing a thermal path for conducting heat from a heat source of an electronic device. In exemplary embodiments, the thermal interface material comprises a metal amalgam including filler particles (*e.g*., metal filler particles, *etc*..) and configured to form a bond line having a thickness of less than 100 micrometers between the heat source and another component of the electronic device to thereby establish the thermal path. Heat is flowable through the thermal path from the heat source during operation of the electronic device whereby temperature of the heat source is reduced.

In exemplary embodiments of the thermal interface material, the metal amalgam is configured to form a bond line having a thickness of about 10 micrometers between the heat source and another component of the electronic device.

In exemplary embodiments of the thermal interface material, the metal amalgam comprises a liquid metal filled with metal filler particles. The liquid metal filled with metal filler particles may be dispensable on the heat component or the another component of the electronic device. The liquid metal filled with metal filler particles may be configured such that the liquid metal filled with metal filler particles is able to hold a bond line thicker than a largest particle size of the metal filler particles. In exemplary embodiments of the thermal interface material, the metal amalgam consists of only metal(s). In such exemplary embodiments, the metal amalgam does not contain any organic solvents and/or organic compounds, which could otherwise reduce wetting and/or lead to voiding from out-gassing during thermal cycling. The metal amalgam does not contain any silicone and/or any polymer components, which could otherwise reduce thermal conductivity.

In exemplary embodiments of the thermal interface material, the metal amalgam comprises gallium, indium, tin, nickel, and copper.

In exemplary embodiments, the metal amalgam comprises nickel particles and copper particles such that the metal amalgam includes a ratio of the nickel to the copper within a range from about 1:1 to about 5:1 by weight percent (wt%) and/or by volume percent (vol%). For example, the metal amalgam may comprise nickel particles and copper particles such that the metal amalgam includes about a 2:1 ratio of nickel to copper by weight percent (wt%) and/or by volume percent (vol%).

In exemplary embodiments, the metal amalgam comprises nickel particles and copper particles such that the metal amalgam is loaded with about 1 percent to about 10 percent of nickel and copper. For example, the metal amalgam may comprise about 5 volume percent (vol%) of nickel particles and about 2.5 volume percent (%vol) of copper particles such that the metal amalgam is loaded with about 7.5 volume percent (vol%) of the nickel particles and the copper particles. Or the metal amalgam may comprise nickel particles and copper particles such that the metal amalgam is loaded with about 4 volume percent (vol%) of the nickel particles and the copper particles.

In exemplary embodiments of the thermal interface material, the reduced bond line thickness of the metal amalgam allows for a reduced overall electronic device thickness and reduced thermal resistance across the thermal joint thereby resulting in a lower temperature for the heat source during operation of the electronic device.

In exemplary embodiments, an electronic device comprises a metal amalgam including metal filled particles that is used as a thermal interface material to establish a thermal path through which heat is flowable from a heat source during operation of the electronic device whereby temperature of the heat source is reduced.

Example embodiments are provided so that this disclosure will be thorough, and will fully convey the scope to those who are skilled in the art. Numerous specific details are set forth such as examples of specific components, electronic devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known electronic device structures, and well-known technologies are not described in detail. In addition, advantages and improvements that may be achieved with one or more exemplary embodiments of the present disclosure are provided for purpose of illustration only and do not limit the scope of the present disclosure, as exemplary embodiments disclosed herein may provide all or none of the above mentioned advantages and improvements and still fall within the scope of the present disclosure.

Specific dimensions, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (*i.e.,* the disclosure of a first value and a second value for a given parameter can be interpreted as disclosing that any value between the first and second values could also be employed for the given parameter). For example, if Parameter X is exemplified herein to have value A and also exemplified to have value Z, it is envisioned that parameter X may have a range of values from about A to about Z. Similarly, it is envisioned that disclosure of two or more ranges of values for a parameter (whether such ranges are nested, overlapping or distinct) subsume all possible combination of ranges for the value that might be claimed using endpoints of the disclosed ranges. For example, if parameter X is exemplified herein to have values in the range of 1 - 10, or 2 - 9, or 3 - 8, it is also envisioned that Parameter X may have other ranges of values including 1 - 9, 1 - 8, 1 - 3, 1 - 2, 2 - 10, 2 - 8, 2 - 3, 3 - 10, and 3 - 9.

The terminology used herein is for the purpose of describing particular example embodiments only and is not intended to be limiting. As used herein, the singular forms "a," "an," and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on," "engaged to," "connected to," or "coupled to" another element or layer, it may be directly on, engaged, connected or coupled to the other element or layer, or intervening elements or layers may be present. In contrast, when an element is referred to as being "directly on," "directly engaged to," "directly connected to," or "directly coupled to" another element or layer, there may be no intervening elements or layers present. Other words used to describe the relationship between elements should be interpreted in a like fashion (*e.g*., "between" versus "directly between," "adjacent" versus "directly adjacent," *etc*.). As used herein, the term "and/or" includes any and all combinations of one or more of the associated listed items.

The term "about" when applied to values indicates that the calculation or the measurement allows some slight imprecision in the value (with some approach to exactness in the value; approximately or reasonably close to the value; nearly). If, for some reason, the imprecision provided by "about" is not otherwise understood in the art with this ordinary meaning, then "about" as used herein indicates at least variations that may arise from ordinary methods of measuring or using such parameters. For example, the terms "generally," "about," and "substantially," may be used herein to mean within manufacturing tolerances. Or, for example, the term "about" as used herein when modifying a quantity of an ingredient or reactant of the invention or employed refers to variation in the numerical quantity that can happen through typical measuring and handling procedures used, for example, when making concentrates or solutions in the real world through inadvertent error in these procedures; through differences in the manufacture, source, or purity of the ingredients employed to make the compositions or carry out the methods; and the like. The term "about" also encompasses amounts that differ due to different equilibrium conditions for a composition resulting from a particular initial mixture. Whether or not modified by the term "about," the claims include equivalents to the quantities.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner," "outer," "beneath," "below," "lower," "above," "upper" and the like, may be used herein for ease of description to describe one element or feature's relationship to another element(s) or feature(s) as illustrated in the figures. Spatially relative terms may be intended to encompass different orientations of the electronic device in use or operation in addition to the orientation depicted in the figures. For example, if the electronic device in the figures is turned over, elements described as "below" or "beneath" other elements or features would then be oriented "above" the other elements or features. Thus, the example term "below" can encompass both an orientation of above and below. The electronic device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. A method of controlling, manipulating, or optimizing bond line thickness of a metal amalgam including filler particles, the method comprising shearing, sonication, and/or vibration of the metal amalgam under pressure to achieve a reduced bond line thickness of the metal amalgam.

2. The method of claim 1, wherein the method includes optimizing bond line thicknesses through an optimal patterning/application method and pattern height, which dictates the achievable reduction in bond line thickness.

3. The method of claim 1 or 2, wherein the method includes shearing the metal amalgam while simultaneously pressing the metal amalgam down to the reduced bond line thickness.

4. The method of claim 1 or 2, wherein the method includes sonication of the metal amalgam while simultaneously pressing the metal amalgam down to the reduced bond line thickness.

5. The method of claim 1 or 2, wherein the method includes vibration of the metal amalgam while simultaneously pressing the metal amalgam down to the reduced bond line thickness.

6. The method of any one of the preceding claims, wherein the method includes shearing, sonication, and/or vibration of the metal amalgam while pressing the metal amalgam down to a minimum bond line thickness.

7. The method of any one of the preceding claims, wherein the method includes:
shearing, sonication, and/or vibration of the metal amalgam while pressing the metal amalgam down to a bond line thickness of less than about 100 micrometers; or
shearing, sonication, and/or vibration of the metal amalgam while pressing the metal amalgam down to a bond line thickness of about 10 micrometers.

8. The method of any one of the preceding claims, wherein the method includes shearing, sonication, and/or vibration of the metal amalgam while pressing the metal amalgam down to a minimum bond line thickness of greater than 10 times an original particle filler size in the metal amalgam.

9. The method of any one of the preceding claims, wherein the method includes dispensing or applying the metal amalgam on a heat source or another component of an electronic device before shearing, sonication, and/or vibration of the metal amalgam under pressure.

10. The method of any one of the preceding claims, wherein the method includes:
dispensing or applying the metal amalgam on a heat source or another component of an electronic device; and
applying a heat sink or another heat dissipation component to the metal amalgam such that a shearing force and pressure are applied to the metal amalgam that reduces or minimizes the bond line thickness of the metal amalgam between the heat source or another component of the electronic device and the heat sink or another heat dissipation component.

11. The method of any one of the preceding claims, wherein:
the metal amalgam comprises a liquid metal filled with metal filler particles; and
the method includes shearing, sonication, and/or vibration of the liquid metal filled with metal filler particles under pressure such that after the shearing, sonication, and/or vibration of the liquid metal filled with metal filler particles under pressure, the liquid metal filled with metal filler particles is controllable and able to hold a bond line thicker than a largest particle size of the metal filler particles.

12. The method of any one of the preceding claims, wherein the method includes:
controlling bond line thickness of the metal amalgam through the filler particle loading of the metal amalgam whereby higher filler particle loadings result in thicker bond line thicknesses of the metal amalgam; and/or
controlling bond line thickness of the metal amalgam through the selection of substrate(s)/surface(s) that contact the metal amalgam during the method whereby smoother substrate(s)/surface(s) result in thicker bond line thicknesses of the metal amalgam.

13. The method of claim 1, wherein:
the metal amalgam comprises a liquid metal filled with metal filler particles; and/or
the metal amalgam consists of only metal(s); and/or
the metal amalgam comprises gallium, indium, tin, nickel, and copper; and/or
the metal amalgam comprises nickel particles and copper particles such that:
the metal amalgam includes a ratio of the nickel to the copper within a range from about 1:1 to about 5:1 by weight percent (wt%) and/or by volume percent (vol%); and/or
the metal amalgam includes about a 2:1 ratio of nickel to copper by weight percent (wt%) and/or by volume percent (vol%); and/or
the metal amalgam is loaded with about 1 percent to about 10 percent of nickel and copper.

14. The method of any one of the preceding claims, wherein the method includes using the metal amalgam having the reduced bond line thickness to form a thermal joint between a heat source of an electronic device and another component of the electronic device, whereby:
the metal amalgam has a bond line thickness of less than 100 micrometers; and/or
the reduced bond line thickness of the metal amalgam forming the thermal joint allows for a reduced overall electronic device thickness and reduced thermal resistance across the thermal joint thereby resulting in a lower temperature for the heat source during operation of the electronic device.

15. A thermal interface material for establishing a thermal path for conducting heat from a heat source of an electronic device, the thermal interface material comprising a metal amalgam including filler particles and configured to form a bond line having a thickness of less than 100 micrometers between the heat source and another component of the electronic device to thereby establish the thermal path, whereby heat is flowable through the thermal path from the heat source during operation of the electronic device whereby temperature of the heat source is reduced, wherein the metal amalgam comprises a liquid metal filled with metal filler particles, and wherein:
the liquid metal filled with metal filler particles is dispensable on the heat source or the another component of the electronic device; and/or
the liquid metal filled with metal filler particles is configured such that the liquid metal filled with metal filler particles is controllable and able to hold a bond line thicker than a largest particle size of the metal filler particles.
